# EUROPEAN PATENT APPLICATION

(11) **EP 0 805 000 A1**
(43) Date of publication of application: **05.11.1997**
(21) Application number: 96303165.3
(22) Date of filing: 02.05.1996
(51) Int. Cl.: B24B 37/04

(54) **Semiconductor wafer post-polish clean and dry method and apparatus**

(71) Applicant: MEMC Electronic Materials, Inc., St. Peters, Missouri 63376 (US)
(72) Inventor: Morgan,Scott, St. Peters Missouri 63376 (US); Hall,Jr.Harold E., St.Peters,Missouri,63376 (US); Adcock,Troy W., St Peters,Missouri,63376 (US); Lenk,James C., St. Peters,Missouri 63376, (US); Wisnieski,Michael S., St Peters,Missouri,63376 (US); Vepe,Krishna, St Peters,Missouri,63376 (US)
(74) Representative: W.P. THOMPSON & CO.

(57) **Abstract**

Method for polishing a semiconductor wafer (12) including the steps of mounting a first face (22) of the wafer (12) on a polishing block (14), attaching the polishing block (14) to a wafer polisher (16) such that a second face (24) of the wafer (12) is exposed to a polishing pad (19) of the wafer polisher (16) for polishing the second face (24) of the wafer (12), polishing the exposed second face (24) of the wafer (12) using the polishing pad (19) of the polishing device (16). The method further includes transferring the polishing block (14) and wafer (12) as a unit (15) after polishing to a cleaning and drying station (10). The polishing block (14) and wafer unit (15) are oriented in the cleaning and drying station (10) so that the second face (24) is accessible for cleaning. Cleaning liquid is delivered to the exposed second face (24) of the wafer (12) for a first selected time to clean particulate matter left after polishing from the exposed second face (24) of the wafer (12). The polishing block (14) and wafer unit (15) is rotated for a second time and at a rate selected to throw liquid off of the second face (24) of the wafer (12) for drying the wafer (12). Apparatus (10) for cleaning and drying a polishing block (14) and wafer unit (15) immediately following polishing is also disclosed.

## Description

### Background of the Invention

This invention relates to the cleaning and drying of semiconductor wafers. More specifically, this invention relates to a method for cleaning and drying a - semiconductor wafer immediately following polishing of the wafer before the wafer is removed from a polishing block.

A final step in a conventional semiconductor wafer shaping process is polishing to produce a highly reflective and damage-free surface on one face of the semiconductor wafer. Polishing of the semiconductor wafer is accomplished by a mechanochemical process in which a rotating polishing pad rubs a polishing slurry against the wafer. In a conventional semiconductor wafer polisher, the wafer is bonded with wax to a polishing block and then held against the rotating polishing pad by a polishing arm. At the conclusion of the polishing process, the surface of the wafer remains wetted by the polishing slurry.

Presently, the wafer is rinsed with de-ionised water after polishing and permitted to air dry while the wafer is still mounted on the polishing block. The de-ionized water rinse, however, fails to remove all the slurry from the wafer. Furthermore, the evaporative drying of the wafer has a detrimental effect on the wafer because it allows residue from the evaporated slurry and de-ionized water to dry on the surface of the water. Once the residue has dried on the surface, it is extremely difficult to remove. After removing the wafer from the polishing block, the wafer is cleaned to remove the wax and then undergoes final inspection and final cleaning. However, the final cleaning does not remove the residue formed on the wafer during the evaporative drying of the wafer after polishing.

### Summary of the Invention

Among the several objects of this invention may be noted the provision of a method and apparatus for cleaning and drying semiconductor wafers immediately after polishing; the provision of such a method and apparatus which remove polishing slurry and rinse liquid from the wafer; the provision of such a method and apparatus which inhibit the formation of dried on residue on the wafer; the provision of such a method and apparatus which minimize evaporative drying; and the provision of such a method and apparatus which operate while the semiconductor wafer is still mounted on a polishing block.

Generally, a method of the present invention for polishing a semiconductor wafer includes the steps of mounting a first face of the wafer on a polishing block, attaching the polishing block to a polisher such that a second face of the wafer is exposed to a polishing pad of the polisher for polishing the exposed second face of the wafer using the polishing pad of the polisher. The method further includes transferring the polishing block and wafer as a unit after polishing to a cleaning and drying station. The polishing block and wafer unit are oriented in the cleaning and drying station so that the second face is accessible for cleaning. Cleaning liquid is delivered to the exposed second face of the wafer for a first selected time to clean the second face of the wafer. The polishing block and wafer unit is then rotated for a second time and at a rate selected to throw liquid off of the second face of the wafer for drying the wafer.

In another aspect of the present invention, an apparatus of the present invention for cleaning and drying the semiconductor wafer and polishing block unit after polishing comprises a housing and a chuck for mounting the polishing block and the wafer unit. A spindle connected to the chuck and supported in the housing is driven by means for rotating the chuck about the longitudinal axis of the spindle. A liquid delivery line is disposed for selectively delivering fluid to the polishing block and wafer unit in the chuck. The chuck is capable of gripping the polishing block with the second face of the wafer facing generally upward to hold the polishing block and wafer unit for rotation with the chuck. The housing comprises a base having an open top through which the polishing block and wafer unit passes for mounting on the chuck and a lid pivotally mounted on the base and capable of swinging motion between a closed position in which the lid closes the open top of the base to retain liquid delivered to the wafer inside the housing and an open position in which the lid is swung away to expose the open top of the base. The liquid delivery line is mounted on the lid for motion therewith such that the line is disposed generally over the center of the chuck in the closed position of the lid. The apparatus further includes actuating means for automatically opening and closing the lid.

Other objects and features will be in part apparent and in part pointed out hereinafter.

### Brief Description of the Drawings

Fig. 1 is a right side elevational view of a cleaning and drying device of the present invention showing an upper portion of the apparatus in cross-section;
Fig. 2 is a top plan view of the cleaning and drying device of Fig. 1;
Fig. 3 is an enlarged top plan view of a chuck of the cleaning and drying device of Fig. 1;
Fig. 4 is a back side elevational view of the cleaning and drying device of Fig. 1 with portions broken away to show internal construction;
Fig. 5 is a fragmentary partial cross-sectional view taken along the plane of line 5--5 of Fig. 3; and
Fig. 6 is a schematic top plan view of a wafer polisher.

Corresponding reference characters indicate parts throughout the several views of the drawings.

### Description of the Preferred Embodiment

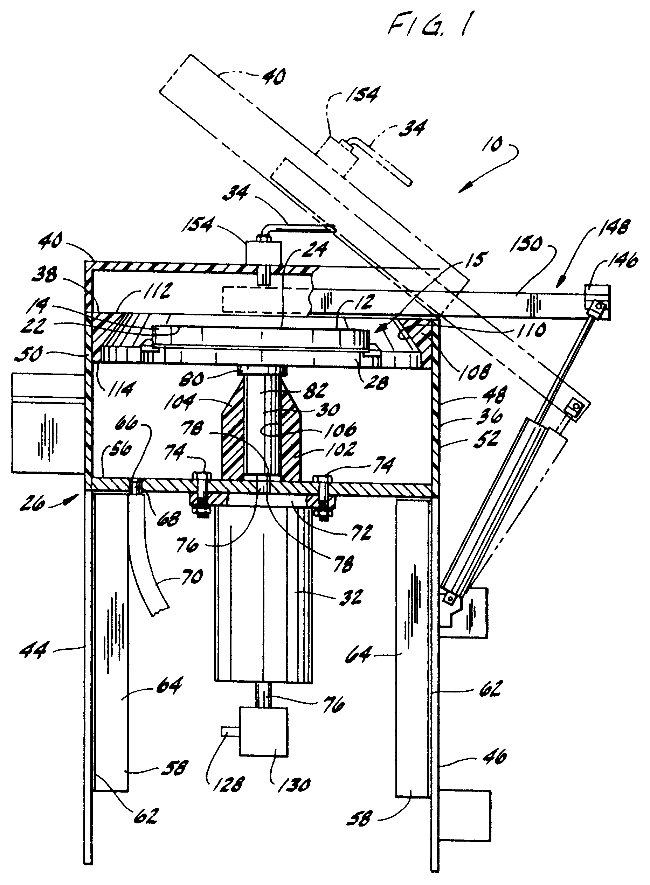

Referring now to the drawings, and first to Fig. 1, a cleaning and drying device of the present invention is generally indicated at 10. The cleaning and drying device 10 is used in cleaning and drying a semiconductor wafer 12 after the wafer has been polished. The wafer 12 is wax mounted for polishing on a rigid polishing block 14 which provides a fixed reference plane. A simplified view of a wafer polisher 16 is shown in Fig. 6. The wafer polisher 16 comprises a polishing table 18 for supporting the polishing pad 19 and a polishing arm 20 for holding the polishing block 14 and forcing it against the polishing pad 19 as the pad rotates beneath it. After mounting a first face 22 of the wafer 12 on the polishing block 14 the polishing block is secured on a chuck 27 at the free end of the polishing arm 20 and a second face 24 of the wafer is pressed against the polishing pad 19 for polishing the second face of the wafer. A polishing slurry including an abrasive solution, etching agents (such as potassium hydroxide), de-ionized water and a neutralizer to stop the etching action of the abrasive solution, is applied to the polishing pad 19. After the polishing of the wafer 12 is completed, the polishing block 14 and wafer are transferred as a unit, generally indicated at 15, to the cleaning and drying device 10. The polishing block and wafer unit 15 are oriented in the cleaning and drying device 10 so that the second face 24 of the wafer 12 is accessible for cleaning. Cleaning liquid is delivered to the exposed face of the wafer 12 for a first selected time. The polishing block and wafer unit 15 is subsequently rotated for a second time at a rate selected to throw liquid off of the second face 24 of the wafer for drying the wafer.

The cleaning and drying device 10 comprises a housing, generally indicated at 26, a chuck 28 for mounting the polishing block and the wafer unit 15, a spindle 30 connected to the chuck, a motor 32 for rotation of the spindle and a liquid delivery line 34. The housing 26 includes a generally rectangular base 36 having an open top 38 through which the polishing block and wafer unit 15 passes for mounting on the chuck 28, and a lid 40 pivotally mounted on the base. The base 36 includes a lower portion comprising a front wall 44 and a back wall 46 and an upper portion comprising a front wall 50, a back wall 52, two side walls 54 and a horizontal plate 56 extending across the lower ends of the walls. The upper portion of the base 36 is mounted on the lower portion of the base with the front wall 50 and back wall 52 of the upper portion of the base aligned with the front wall 44 and back wall 46 of the lower portion of the base. The lid 40 is preferably made of a clear plastic material (e.g., Lexan) so that the cleaning and drying may be observed from outside the housing 26. The housing 26 further includes mounting brackets 58 attached to the front wall 44 and back wall 46 of the lower portion of the base 36. Each bracket 58 includes a horizontal section 60 attached to the plate 56 and a vertical section 62 attached to the corresponding wall 44, 46. The vertical section 62 includes a flange 64 extending inward from the wall for attachment to the wafer polisher 16.

The upper portion of the base 36 is exposed to the cleaning liquid and water, whereas the lower portion 42 contains the motor 32 and is kept dry. The walls 50, 52, 54 of the upper portion are made of white polypropylene in the preferred embodiment. The plate 56 is preferably made from stainless steel and connected to each side wall 54 by screws. The plate 56 includes a drain hole 66 and a hole 78 in the center of the plate through which a motor drive shaft 76 passes. De-ionized water and other liquid that is supplied to the wafer 12 during the cleaning process collects on the plate 56 and is drained by way of the drain hole 66. A fitting 68 is inserted into the drain hole 66 and connected to a drain tube 70 which is used to drain the liquid from the upper portion of the base 36 to a floor drain (not shown). The plate 56 is further used to support the electric motor 32 as shown in Fig. 1. The electric motor 32 for driving the chuck 28 and polishing block and wafer unit 15 is 1/4 hp in the preferred embodiment. The motor 32 includes a flange 72 which is attached to the plate 56 by bolts 74 with the motor being suspended from the plate in a position such that the motor shaft 76 is aligned with the hole 78 in the center of the plate to allow the motor drive shaft to pass through to the upper portion of the base 36 of the housing 26.

The motor drive shaft 76 is connected to the spindle 30 for rotating the chuck 28 about the longitudinal axis of the spindle. The spindle 30 includes a head portion 80 and a body portion 82 and may for example be about 3.5 inches in height. The head and body portions 80, 82 contain a passageway 84 extending through the center thereof. The bottom portion 86 of the passageway 84 is sized for reception of the motor drive shaft 76 and the upper portion 88 of the passageway is sized for insertion of a bolt 90 for connecting the chuck 28 to the spindle 30. The drive motor shaft 76 is inserted into the bottom opening 86 of a center hole 84 in the spindle 30 and attached for conjoint rotation therewith. The bolt 90 includes a shank 92 which extends from a lower surface 93 of the chuck 28 and is inserted into the upper opening 88 of the center hole 84 of the spindle 30. The head in an upper surface 101 of the head portion 80 of the spindle 30 further includes two alignment holes 94 on opposite sides of the center hole 84. Alignment pins 96 are inserted into the alignment holes 94 of the spindle 30 for connection with the chuck 28. The spindle 30 also includes a groove 98, which contains an O-ring 100, in the upper surface 101 between the center hole 84 and the alignment holes 94. The purpose of this O-ring 100 will be discussed hereinafter.

A tubular spindle shield 102 is provided to protect the spindle 30 and associated rotating parts from cleaning liquid and de-ionized water. The spindle shield 102 is generally cylindrically shaped with a upper nose portion 104 tapered inward. The spindle shield 102 includes a longitudinal passage 106 sized for receiving the spindle 30 and motor shaft 76 through the shield. The spindle shield 102 is sealingly attached to the plate 56 for keeping liquid away from the central opening 78 and motor 32. A splash shield 108 is also provided to direct de-ionized water and cleaning liquid that is thrown radially outwardly from the exposed surface of the wafer 12 in a downward direction to prevent liquid from being splashed onto the inside surface of the lid 40 where it can collect and later drip onto the wafer. The splash shield 108 is generally rectangular shaped and has and an inner conically shaped opening 110 that tapers outwardly from the top side 112 of the shield toward its bottom side 114. The splash shield 108 is connected to the walls 50, 52, 54 in the upper portion of the base 36 at a location such that a conical inner side wall 116 defining the opening 110 surrounds the chuck 28 and polishing block and wafer unit 15.

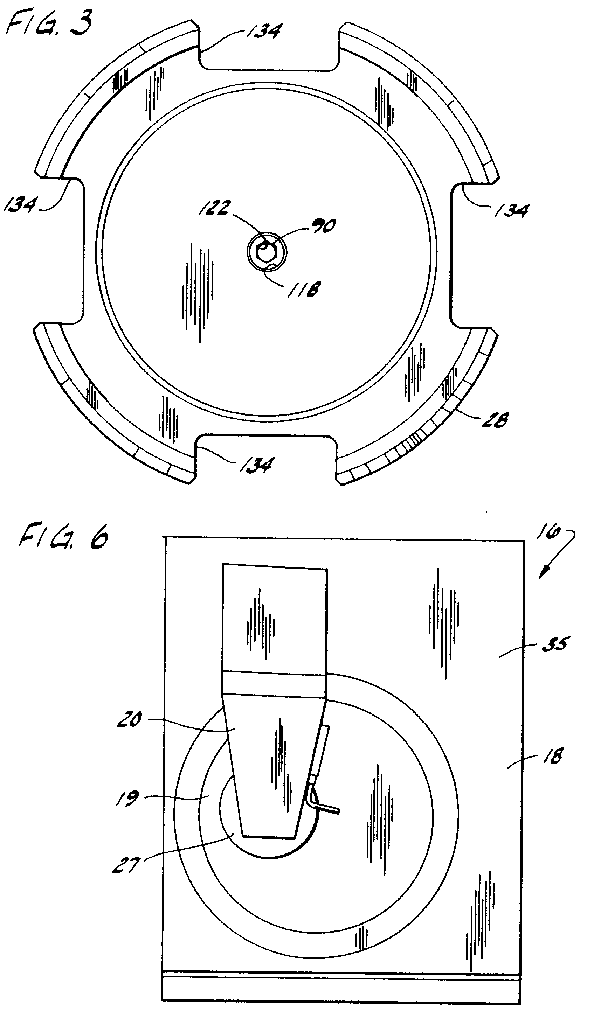

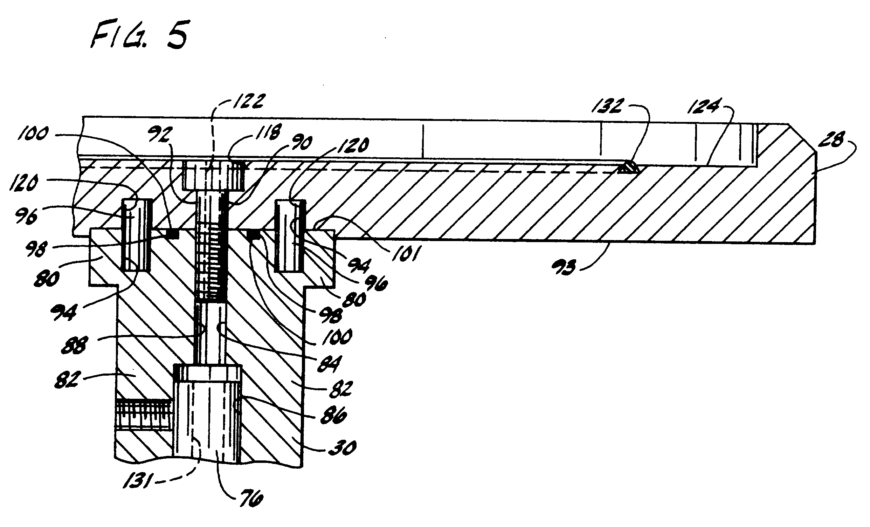

The chuck 28 shown in Figs. 1, 3 and 5 is a vacuum chuck, but it is to be understood that other types of chucks such as mechanical gripper type chucks may be used without departing from the scope of this invention. The polishing block 14 is placed on top of the chuck with the wafer 12 facing upward and the chuck 28 uses vacuum pressure to securely hold the polishing block and wafer unit 15 in place. As shown in Figs. 3 and 5, the chuck 28 includes an opening 118 in the center thereof for insertion of the bolt 90 for connection with the spindle 30 as previously described. The chuck 28 further includes two openings 120 aligned with the two alignment holes 94 on the spindle 30 for receiving the alignment pins 96.

The bolt 90 includes a longitudinal passage 122 for transmission of vacuum pressure from the spindle 30 to the face of the chuck 28. The passage 122 must be sufficiently large to allow enough vacuum pressure to be applied to the polishing block resting on the chuck 28 to hold it securely in place. The vacuum pressure is controlled by a vacuum solenoid valve 126. When the solenoid valve 126 is energized, it allows transmission of vacuum pressure provided by a pump (not shown) through the solenoid valve and into tubing 128 connected to a rotary vacuum union 130. The union 130 connects the vacuum pressure tube 128 to the hollow motor drive shaft 76 which is connected to the union by bearings allowing for rotation of the shaft relative to the union. The hollow drive shaft 76 provides a passageway 131 for communication of the vacuum pressure from the rotary vacuum union 130 to the spindle 30. The vacuum pressure is transmitted through the spindle 30 and bolt passage 122 to the upper surface 124 of the chuck 28. In order to prevent leakage of vacuum pressure, an O-ring 132 is provided at the spindle to chuck interface. The O-ring 132 on the upper surface 124 of the chuck 28 provides a sealing surface with the polishing block 14 and allows for greater gripping strength of the chuck.

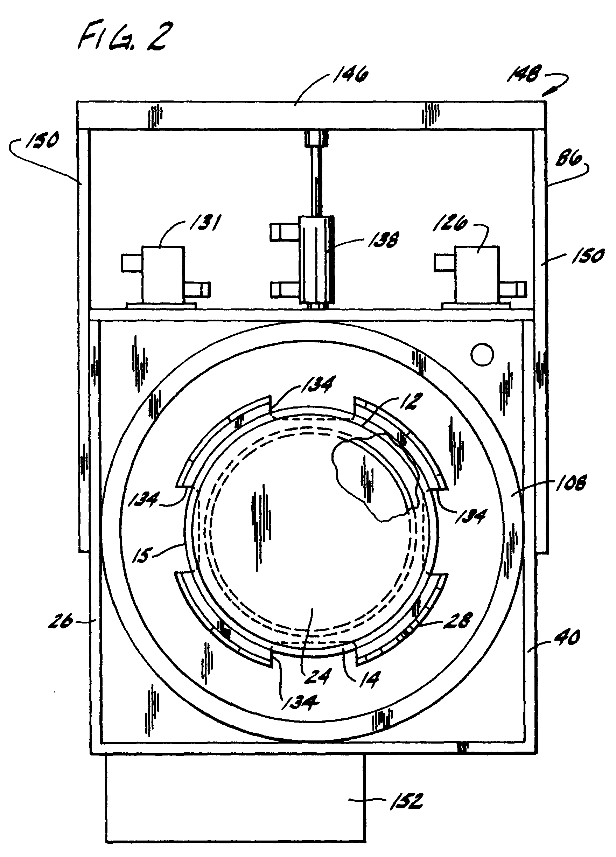

As shown in Fig. 3, the chuck 28 has notches 134 formed in the chuck and spaced around the periphery thereof. The notches 134 are provided to allow either manual or robotic grasping of the polishing block 14 to place it in or remove it from the chuck 28. As can be seen in Fig. 2, the polishing block 14 extends over the notches 134 formed in the chuck 28, thus allowing a person or a robotic arm to reach under the polishing block 14 and support the block by engagement with its underside. This provides for easy placement and removal of the polishing block and wafer unit 15 without touching the surface of the semiconductor wafer 12.

Access to the polishing block and wafer unit 15 is provided through the opening 38 in the top of the base 36 when the lid 40 is in its open position as shown in phantom in Fig. 1. The lid 40 is pivotally mounted at its rear by hinges 39 to the upper portion 48 of the base 36 and is capable of swinging motion between a closed position in which the lid closes the open top 38 of the base to retain liquid delivered to the wafer 12 inside the housing 26 and an open position in which the lid is swung away to expose the open top of the base so that it is not in the way when a polishing block and wafer unit 15 is placed on the chuck 28. The liquid delivery line 34 is mounted on the lid 40 for motion therewith such that the line is disposed generally over the center of the chuck 28 in the closed position of the lid. The delivery line 34 is inserted through an opening in a delivery line fixture 154 which is connected to the lid 40. The liquid delivery line 34 is flexible to permit rotation of the line with the lid 40 from a closed position to an open position and vice versa. The liquid delivery line 34 is disposed above the semiconductor wafer 12 for selectively delivering cleaning fluid to the second face 24 of the wafer. The delivery line 34 is generally directed toward the center of the second face 24 of the wafer 12. The delivery line 34 may be used to spray various types of cleaning liquid or rinse or a combination of both on the second face 24 of the semiconductor wafer 12 to remove particulate matter left from the polishing process.

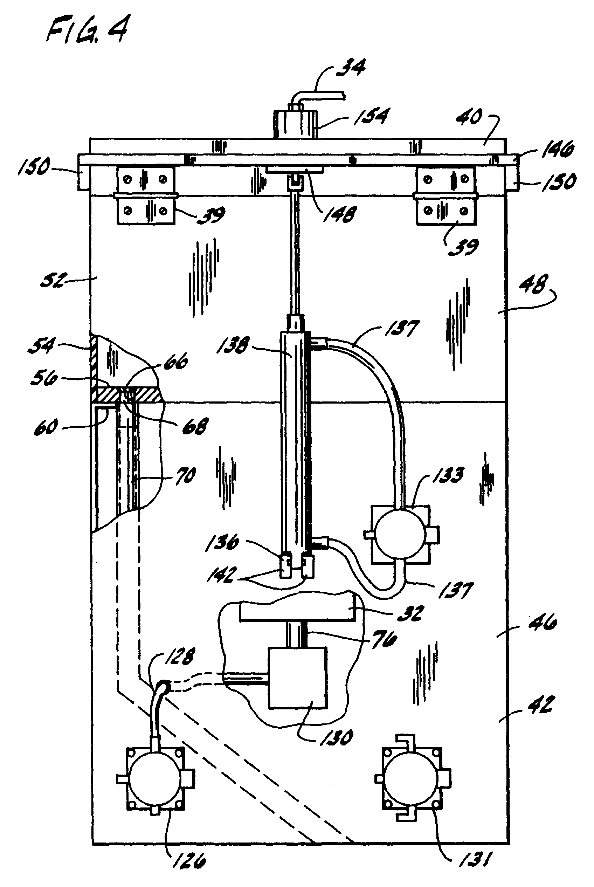

The cleaning and drying device 10 also includes actuating means for automatically opening and closing the lid 40. The actuating means includes a pneumatic cylinder 138 pivotally connected at its barrel end to ears 142 projecting rearwardly from the back wall 46 of the lower portion 42 of the base 36. The rod end of the cylinder 138 is pivotally connected to a cross member 146 of a lid bracket indicated generally at 148. The lid bracket 148 further includes arms 150 extending forwardly from opposite ends of the cross member 146 and connected to the lid 40 on opposite sides thereof. Actuation of the cylinder 138 swings the lid 40 and liquid delivery line 34 from the closed position (shown in Fig. 1) to the open position (shown in phantom in Fig. 1). The lid cylinder 138 shown in Figs. 1, 2 and 4 is controlled by a lid cylinder solenoid valve 131 which is connected by tubing 137 to both ends of the cylinder. Upon energization of the solenoid valve 131, air is applied to either the front of a piston head of the cylinder 138 to close the lid 40 or to the back side of the piston head to open the lid. The solenoid valve 131 may be any standard four way three position valve or other suitable device. It is to be understood that other types of actuators may be used to open and close the lid 40 without departing from the scope of this invention.

A control panel 152 mounted on the housing has switches (not shown) for energizing and de-energizing the vacuum solenoid valve 126 and the lid cylinder solenoid valve 131. It is to be understood that an "electrical control circuit" for controlling operation of the device may be manually operated switches, hardwired control circuitry or a microprocessor. Of course, only the hardwired circuitry and microprocessor are capable of being pre-programmed.

In operation, the lid 40 is initially in its raised position for receiving a polishing block and wafer unit 15 in the cleaning and drying device 10. The polishing block and wafer unit 15 is held in a position such that the unit may be lowered onto the chuck 28 with the fingers of the person lowering the unit passing through the notches 134 formed in the chuck. After the polishing block 14 is placed on the chuck 28, the vacuum solenoid valve 126 is energized and vacuum pressure is applied to hold the polishing block and wafer unit 15 on the chuck. The pneumatic cylinder 138 is then actuated to close the lid 40 and the motor 32 is energized to spin the chuck 28 and polishing block and wafer unit 15. A cleaning solution is sprayed via the liquid delivery line 34 on the second face 24 of the wafer 12 to clean the wafer. The cleaning solution may be an ammonium, water and hydrogen peroxide solution such as SC₁. This cleaning solution aggressively removes the polishing slurry and forms a thin oxide layer on the wafer 12, which is helpful in later cleaning steps. During the cleaning process, the wafer 12 is rotated at a speed of between 100 and 300 revolutions per minute (rpm) and preferably about 200 rpm. This permits cleaning solution applied to the wafer 12 at its center to be uniformly distributed over the face of the wafer. At these speeds, excess cleaning solution is thrown radially outward onto the splash shield 108 where it is directed downward toward the plate 56 extending across the base 36 and eventually flows out of the housing 26 through the drain tube 70. The spindle shield 102 provides protection of the rotating parts from the cleaning solution. The cleaning solution is applied for a period of time sufficient to remove all of the polishing slurry from the face of the semiconductor wafer 12. It would also be within the scope of the present invention to apply the cleaning solution to the second face 24 of the wafer 12 with the wafer stationary.

Following the cleaning process, the semiconductor wafer 12 undergoes a drying process. The rotation rate of the polishing block and wafer unit 15 during the drying phase is faster than the rate selected for cleaning the wafer. The drying rotation rate is generally between 900 and 1200 rpm and preferably about 1000 rpm. The speed selected is preferably fast enough to cause the liquid and non-liquids suspended or dissolved in the liquid, to be thrown from the surface of the wafer 12. In this way, evaporative drying of the wafer is avoided, thus eliminating the buildup of a chemical residue from the polishing slurry and de-ionized water on the face of the semiconductor wafer. The typical time required to dry the wafer 12 at these speeds is between 60 and 90 seconds. It is to be understood that the speeds and times for cleaning and drying the wafer 12 may vary without departing from the scope of the invention. In the preferred embodiment the motor 32 is operated at two discrete speeds, one for cleaning and one for drying. However, it is also envisioned that the cleaning solution could be applied to the wafer 12 as it is being accelerated toward its drying speed.

After the drying process is completed, the rotation of the wafer and polishing block unit 15 is stopped, the lid cylinder 138 is actuated to open the lid 40 and the vacuum solenoid valve 126 is closed to permit removal of the polishing block and semiconductor wafer unit 15 from the vacuum chuck 28. To remove the polishing block and wafer unit 15 from the chuck 28, the polishing block 14 is grasped at the locations of the notches 134 formed in the chuck. The notches 134 permit a person to reach under the polishing block and wafer unit 15 with his fingers in the notches, and lift the unit off the chuck 28. The polishing block and wafer unit 15 is then transferred to a separation station (not shown) for removal of the wafer 12 from the polishing block 14. The semiconductor wafer 12 is then ready for final measurement and cleaning.

In view of the above, it will be seen that the several objects of the invention are achieved and other advantageous results attained.

As various changes could be made in the above constructions and methods without departing from the scope of the invention, it is intended that all matter contained in the above description or shown in the accompanying drawings shall be interpreted as illustrative and not in a limiting sense.

## Claims

1. A method for polishing a semiconductor wafer comprising the steps of mounting a first face (22) of the wafer (12) on a polishing block (14), attaching the polishing block to a wafer polisher (16) such that a second face (24) of the wafer is exposed to a polishing pad (19) of the wafer polisher for polishing the second face of the wafer, polishing the exposed second face of the wafer using the polishing pad of the wafer polisher, the method being characterized in that the polishing block and wafer are transferred as a unit after polishing to a cleaning and drying station (10), the polishing block and wafer unit are oriented in the cleaning and drying station so that the second face is accessible for cleaning, cleaning liquid is delivered to the exposed second face of the wafer for a first selected time to clean the second face of the wafer, the polishing block and wafer unit is rotated for a second time and at a rate selected to throw liquid off of the second face of the wafer for drying the wafer.

2. A method as set forth in claim 1 further characterized in that the polishing block and wafer unit (15) is rotated as the cleaning liquid is delivered to the second face (24) of the wafer (12).

3. A method as set forth in claim 2 characterized in that the wafer (12) is rotated during delivery of cleaning fluid to the second face (24) of the wafer at a rate slower than the rate selected for drying the wafer.

4. A method as set forth in claim 1 characterized in that the first and second rotation rates are controlled by a pre-programmed electronic control circuit.

5. A method as set forth in claim 1 characterized in that selected rate of rotation of the unit (15) during delivery of the cleaning liquid is between 100 and 300 revolutions per minute.

6. A method as set forth in claim 5 characterized in that the selected rate of rotation of the unit (15) during delivery of the cleaning liquid is about 200 revolutions per minute.

7. A method as set forth in claim 1 characterized in that the selected rate of rotation of the unit (15) for drying the wafer is between 900 and 1200 revolutions per minute.

8. A method as set forth in claim 7 characterized in that rotation of the unit (15) at a second rate is about 1000 revolutions per minute.

9. A method as set forth in claim 1 characterized in that the selected second time is between 60 and 90 seconds.

10. Apparatus for cleaning and drying a semiconductor wafer (12) having a first face (22) mounted on a polishing block (14) such that the wafer and polishing block form a unit (15), and a second exposed face (24) following polishing of the second face of the wafer on a wafer polisher, the apparatus (10) comprising a housing (26), a chuck (28) for mounting the polishing block and the wafer unit, a spindle (30) connected to the chuck and supported in the housing for rotating the chuck about the longitudinal axis of the spindle, means for driving rotation of the spindle, a liquid delivery line (34) disposed for selectively delivering cleaning fluid to the polishing block and wafer unit in the chuck, the apparatus being characterized in that the chuck is capable of gripping the polishing block with the second face of the wafer facing generally upward to hold the polishing block and wafer unit for rotation with the chuck, the housing comprises a base (36) having an open top through which the polishing block and wafer unit passes for mounting on the chuck and a lid (40) pivotally mounted on the base and capable of swinging motion between a closed position in which the lid closes the open top of the base to retain liquid delivered to the wafer inside the housing and an open position in which the lid is swung away to expose the open top of the base, the liquid delivery line being mounted on the lid for motion therewith such that the line is disposed generally over the center of the chuck in the closed position of the lid, and further characterized in that the apparatus includes actuating means (138) for automatically opening and closing the lid.
